(19) Europäisches Patentamt / European Patent Office / Office européen des brevets

(11) **EP 3 545 319 B1**

(12) **FASCICULE DE BREVET EUROPEEN**

(45) Date de publication et mention de la délivrance du brevet:
**31.08.2022  Bulletin 2022/35**

(21) Numéro de dépôt: **17803929.3**

(22) Date de dépôt: **22.11.2017**

(51) Classification Internationale des Brevets (IPC):
**G01R 31/08** (2020.01)

(52) Classification Coopérative des Brevets (CPC):
**G01R 31/086**

(86) Numéro de dépôt international:
**PCT/EP2017/080101**

(87) Numéro de publication internationale:
**WO 2018/095985 (31.05.2018 Gazette 2018/22)**

(54) **PROCEDE ET DISPOSITIF D'ANALYSE DE DEFAUT DANS UN RESEAU DE LIGNES DE TRANSMISSION**

VERFAHREN UND VORRICHTUNG ZUR ANALYSE VON FEHLERN IN EINEM ÜBERTRAGUNGSLEITUNGSNETZ

METHOD AND DEVICE FOR ANALYSING FAULTS IN A TRANSMISSION LINE NETWORK

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.11.2016  FR 1661491**

(43) Date de publication de la demande:
**02.10.2019  Bulletin 2019/40**

(73) Titulaire: **Commissariat à l'Énergie Atomique et aux Énergies Alternatives**
**75015 Paris (FR)**

(72) Inventeurs:
 • **BENOIT, Jaume**
   **91120 Palaiseau (FR)**
 • **DUPRET, Antoine**
   **91400 Orsay (FR)**

(74) Mandataire: **Marks & Clerk France**
**Immeuble "Visium"**
**22, avenue Aristide Briand**
**94117 Arcueil Cedex (FR)**

(56) Documents cités:
**US-A1- 2014 300 370**

 • **RAZZAGHI R ET AL: "On the use of electromagnetic time reversal to locate faults in series-compensated transmission lines", 2013 IEEE GRENOBLE CONFERENCE, IEEE, 16 juin 2013 (2013-06-16), pages 1-5, XP032519859, DOI: 10.1109/PTC.2013.6652101**
 • **MANESH H M ET AL: "A new method to locate faults in power networks based on Electromagnetic Time Reversal", SIGNAL PROCESSING ADVANCES IN WIRELESS COMMUNICATIONS (SPAWC), 2012 IEEE 13TH INTERNATIONAL WORKSHOP ON, IEEE, 17 juin 2012 (2012-06-17), pages 469-474, XP032231251, DOI: 10.1109/SPAWC.2012.6292952 ISBN: 978-1-4673-0970-7**
 • **GAUGAZ FRANCOIS ET AL: "Implementation guidelines for a real-time fault location system in electrical power networks", 2016 15TH BIENNIAL BALTIC ELECTRONICS CONFERENCE (BEC), IEEE, 3 octobre 2016 (2016-10-03), pages 47-50, XP033005326, DOI: 10.1109/BEC.2016.7743725**
 • **REZA RAZZAGHI ET AL: "An Efficient Method Based on the Electromagnetic Time Reversal to Locate Faults in Power Networks", IEEE TRANSACTIONS ON POWER DELIVERY, IEEE SERVICE CENTER, NEW YORK, NY, US, vol. 28, no. 3, 1 juillet 2013 (2013-07-01), pages 1663-1673, XP011515988, ISSN: 0885-8977, DOI: 10.1109/TPWRD.2013.2251911**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

• Lola El Sahmarany: "Méthodes d'amélioration pour le diagnostic de câble par réflectométrie", , 17 décembre 2013 (2013-12-17), pages 1-196, XP055313254, Clermont Ferrand, France Extrait de l'Internet: URL:https://tel.archives-ouvertes.fr/tel-0 0999462/document [extrait le 2016-10-24]

**Description**

L'invention concerne le domaine des systèmes de diagnostic filaires et plus précisément ceux qui visent à localiser des défauts intermittents (par exemple des courts-circuits) dans un réseau de lignes de transmission.

L'invention s'applique à tout type de câble électrique, en particulier des câbles de transmission d'énergie, dans des installations fixes ou mobiles. Les câbles concernés peuvent être coaxiaux, bifilaires, en lignes parallèles, en paires torsadées ou autre.

Les câbles, ou plus généralement les lignes de transmission, sont omniprésents dans tous les systèmes électriques, pour l'alimentation ou la transmission d'information. Ces câbles sont soumis aux mêmes contraintes que les systèmes qu'ils relient et peuvent être sujets à des défaillances. En particulier, des défauts intermittents peuvent apparaître et il est important de pouvoir détecter et localiser de tels défauts afin d'améliorer la maintenance des câbles.

Ce problème est d'autant plus complexe à résoudre lorsqu'il s'agit d'un réseau de lignes de transmission composé de nombreux segments de lignes interconnectés entre eux par des jonctions.

Une solution connue pour localiser spatialement et temporellement un défaut intermittent dans un réseau de câbles est basée sur le principe du retournement temporel introduit par Mathias Fink dans la référence « M. Fink, "Time Reversai of ultrasonic fields - Basic principles", IEEE Trans. Ultrason., Ferroelec., Freq. Contr. vol. 39, no. 5, pp. 555-566, 1992 ».

Ce principe a été établi en premier lieu dans le domaine de l'acoustique mais s'est révélé être applicable également dans le domaine de l'électromagnétisme et puis généralement dans tous les domaines régis par les lois de propagation des ondes.

Les équations de propagation d'une onde dans une ligne de transmission s'écrivent :

$$\frac{\partial^2 V}{\partial z^2} = LC \frac{\partial^2 V}{\partial t^2} + (RC + LG)\frac{\partial V}{\partial t} + RGV$$

$$\frac{\partial^2 I}{\partial z^2} = LC \frac{\partial^2 I}{\partial t^2} + (RC + LG)\frac{\partial I}{\partial t} + RGI$$

I et V représentent respectivement l'intensité et la tension dans la ligne de transmission.

R,L,C et G représentent respectivement la résistance, l'inductance, la capacitance et la conductance de la ligne de transmission.

Lorsque les pertes dans la ligne de transmission sont négligées, la résistance et la conductance peuvent être considérées comme étant nulles et les équations précédentes prennent alors la forme suivante :

$$\frac{\partial^2 \varphi}{\partial z^2} = LC \frac{\partial^2 \varphi}{\partial t^2}$$

$\varphi = \varphi(z, t)$ représente l'intensité ou la tension. L'absence de dérivée du premier ordre dans l'équation ci-dessus conduit à l'existence d'une deuxième solution $\varphi = \varphi(z, -t)$ qui correspond à la première solution $\varphi = \varphi(z, t)$ retournée temporellement.

Ce principe peut être utilisé notamment pour localiser un défaut en un point d'un réseau de câble qui peut être vu comme une source émettrice secondaire. En effet, un défaut intermittent de type court-circuit peut générer une onde de choc ayant sa source à l'endroit du défaut et se propageant jusqu'aux extrémités des câbles qui composent le réseau.

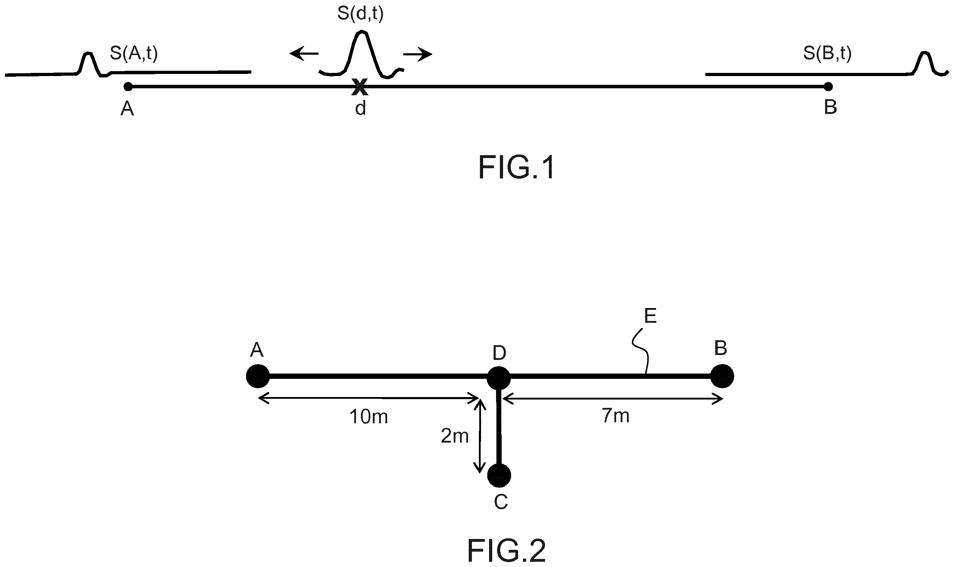

Ce principe est représenté schématiquement à la figure 1 pour une ligne de transmission simple à deux extrémités A et B et un défaut intervenant à un instant $t_0$ et au point d. Le défaut se comporte comme une source positionnée au point d et qui génère à un instant $t_0$ une onde de choc qui a la forme d'une impulsion. Cette onde de choc génère des signaux qui se propagent en provenance de l'emplacement d du défaut. Ces signaux peuvent être enregistrés par des appareils de mesure (par exemple des oscilloscopes) aux extrémités A et B de la ligne et notés S(A,t) et S(B,t). Dans une seconde phase, les signaux enregistrés sont retournés temporellement S(A,-t), S(B,-t). Ensuite, en réinjectant les signaux retournés temporellement aux mêmes points (A, respectivement B) où ils ont été mesurés et de façon synchronisée, il est possible de faire réapparaitre, à l'endroit où le défaut s'est produit, la même onde de choc générée initialement par le défaut.

Pour pouvoir localiser le défaut, il faudrait être capable d'enregistrer simultanément, en tous points de la ligne de transmission, l'intensité et la tension afin de détecter l'instant et l'emplacement de la re-focalisation de l'onde de choc.

En pratique, un tel traitement n'est pas possible et on le remplace par une méthode numérique qui consiste à résoudre les équations aux dérivées partielles introduites précédemment pour calculer l'intensité et la tension en tout point du réseau de lignes de transmission et à chaque instant afin de déterminer la position et l'instant d'apparition du défaut en recherchant l'énergie maximale.

Cette phase de résolution numérique peut s'avérer extrêmement couteuse en temps de calcul et occupation mémoire d'autant plus que le réseau de câbles est grand et/ou la localisation finement résolue.

Afin de diminuer la complexité d'exécution de la phase de résolution numérique d'une méthode classique basée sur le retournement temporel, l'invention propose un procédé qui consiste à exprimer de façon simplifiée la tension (ou l'intensité) en tout point d'un réseau de câbles et à tout instant et à rechercher les extrema de cette fonction en utilisant un algorithme d'optimisation sous contraintes.

La demande de brevet US 2014/0300370 décrit une autre méthode de localisation de défaut exploitant une technique de retournement temporel.

L'invention a pour objet un procédé d'analyse de défaut impactant un réseau de lignes de transmission comprenant au moins un segment de ligne et ayant plusieurs extrémités, ledit procédé comprenant les étapes de :

- Acquérir, en au moins deux extrémités du réseau de lignes, une mesure d'un signal se propageant dans le réseau de lignes,
- Appliquer un retournement temporel à chaque mesure de signal,
- Pour chaque segment du réseau de lignes, construire une fonction de coût dépendante du temps et de la distance d'un point du segment à une extrémité du réseau de lignes, en sommant les mesures de signaux retournés temporellement et retardés du temps de propagation du signal entre un point du segment et l'extrémité du réseau de lignes associée à la mesure,
- Rechercher au moins un extremum de la fonction de coût sur l'ensemble des segments du réseau de lignes et retenir les coordonnées de l'extremum,
- En déduire la présence d'un défaut à une position et un instant d'apparition donnés par les coordonnées de l'extremum.

Selon une variante particulière de l'invention, pour construire la fonction de coût, les mesures de signaux retournés temporellement et retardés sont pondérées par une estimée de l'inverse du coefficient de transmission cumulé entre l'extrémité associée à la mesure et le segment du réseau de lignes.

Selon une variante particulière de l'invention, pour construire la fonction de coût, les mesures de signaux retournés temporellement et retardés sont pondérées par une estimée d'un coefficient d'atténuation dépendant de la distance entre un point du segment et l'extrémité du réseau de lignes associée à la mesure.

Selon une variante particulière de l'invention, l'estimée d'un coefficient d'atténuation dépend du segment de réseau de lignes.

Selon une variante particulière, le procédé selon l'invention comprend en outre la construction d'une fonction de coût par morceaux définie sur plusieurs intervalles par la fonction de coût correspondant à chaque segment du réseau de lignes.

Selon une variante particulière de l'invention, la recherche d'au moins un extremum de la fonction de coût est réalisée au moyen d'un algorithme d'optimisation du type algorithme de descente du gradient.

Selon une variante particulière, le procédé selon l'invention comprend au préalable une détection d'impulsion caractéristique de la présence d'un défaut dans au moins une des mesures.

L'invention a également pour objet un dispositif d'analyse de défaut impactant un réseau de lignes de transmission comprenant au moins un segment de ligne et ayant plusieurs extrémités, le dispositif comprenant :

- au moins un appareil de mesure pour acquérir, en au moins deux extrémités du réseau de lignes, une mesure d'un signal se propageant dans le réseau de lignes,
- un composant configuré pour :

  • Appliquer un retournement temporel à chaque mesure de signal,
  • Pour chaque segment du réseau de lignes, construire une fonction de coût dépendante du temps et de la distance d'un point du segment à une extrémité du réseau de lignes, en sommant les mesures de signaux retournés temporellement et retardés du temps de propagation du signal entre un point du segment et l'extrémité du réseau de lignes associée à la mesure,
  • Rechercher au moins un extremum de la fonction de coût sur l'ensemble des segments du réseau de lignes et retenir les coordonnées de l'extremum,
  • En déduire la présence d'un défaut à une position et un instant d'apparition donnés par les coordonnées de l'extremum.

Le dispositif d'analyse de défaut selon l'invention peut comprendre en outre un moyen d'affichage de la position et de l'instant d'apparition d'un défaut.

L'invention a encore pour objet un programme d'ordinateur comportant des instructions pour l'exécution du procédé d'analyse de défauts selon l'invention, lorsque le programme est exécuté par un processeur ainsi qu'un support d'enregistrement lisible par un processeur sur lequel est enregistré un programme comportant des instructions pour l'exécution du procédé d'analyse de défauts selon l'invention, lorsque le programme est exécuté par un processeur.

D'autres caractéristiques et avantages de la présente invention apparaîtront mieux à la lecture de la description qui suit en relation aux dessins annexés qui représentent :

- La figure 1, un schéma d'une ligne de transmission présentant un défaut source de génération d'un signal,
- La figure 2, un schéma d'un réseau de lignes de transmission comprenant trois segments de lignes et un défaut intermittent,
- Les figures 3a, 3b,3c, trois exemples de mesures du signal généré par le défaut et rétro-propagé jusqu'aux trois extrémités du réseau,
- La figure 4, un schéma d'une représentation différente du réseau de la figure 2,
- La figure 5, un organigramme détaillant les étapes de mise en œuvre du procédé selon l'invention,
- La figure 6, un schéma d'un exemple de réalisation d'un dispositif de détection selon l'invention.

L'invention s'applique pour toute ligne de transmission ou plus généralement tout réseau de lignes de transmission formé de segments de lignes interconnectés par des jonctions. Un exemple de réseau de lignes est représenté à la figure 2. Cet exemple illustre un réseau composé de trois segments de lignes [AD], [DB] et [DC] de tailles différentes, les segments étant connectés par la jonction D.

Un défaut intermittent apparait à un instant $t_0$ au point E du segment [DB]. Le défaut agit comme une source qui génère une onde de choc qui a la forme d'une impulsion qui se propage vers les extrémités A,B et C du réseau.

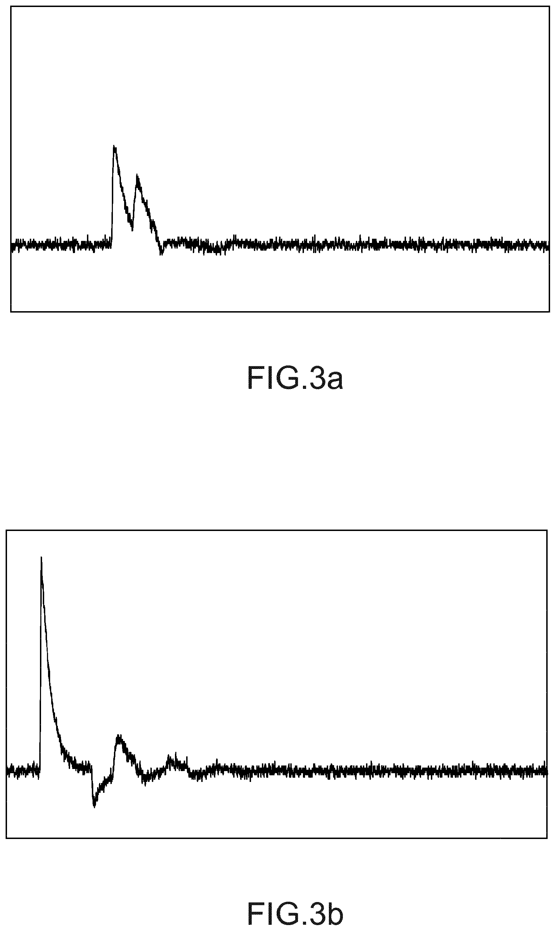

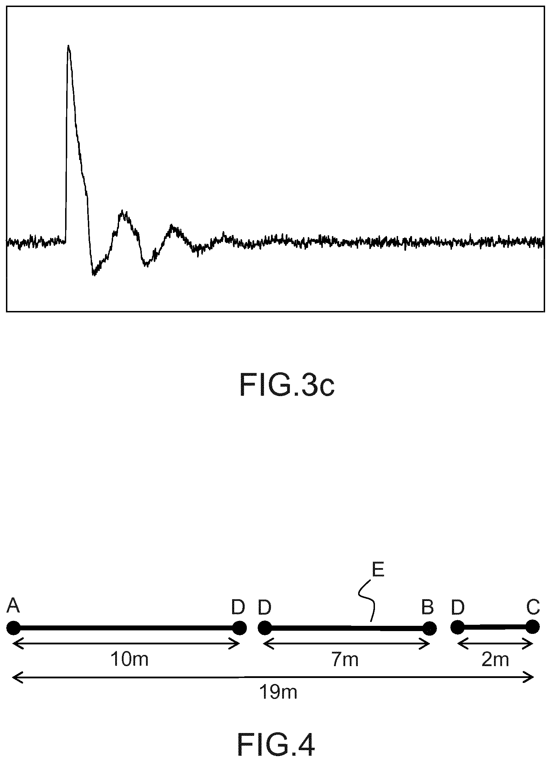

On a représenté sur les figures 3a,3b et 3c, des exemples de signaux mesurés respectivement aux extrémités A,B et C lorsqu'un défaut intermittent se produit au point E. Sur les trois mesures, on peut identifier la signature du défaut qui a généré l'onde de choc.

Ces trois mesures (ou plus généralement N mesures dans le cas d'un réseau à N extrémités) sont exploitées par l'invention pour déterminer l'instant d'apparition et la position E du défaut.

Une extrémité d'un réseau filaire correspond à une extrémité d'un câble compris dans ce réseau et qui n'est pas reliée à d'autres câbles du réseau.

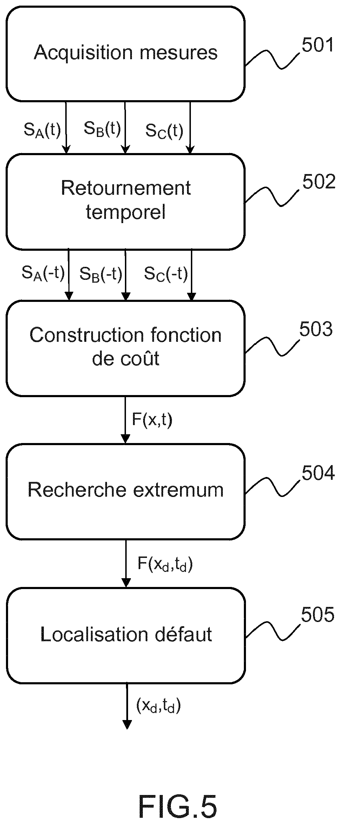

Les étapes du procédé selon l'invention sont illustrées sur l'organigramme de la figure 5.

Dans une première étape 501, on effectue une mesure du signal reçu à chaque extrémité du réseau filaire dans lequel on souhaite détecter et localiser un défaut. Les mesures peuvent être faites au moyen d'appareils de mesure aptes à enregistrer un signal se propageant dans une ligne de transmission. Les appareils de mesure peuvent effectuer les enregistrements directement aux extrémités des lignes du réseau mais peuvent également réaliser les enregistrements en d'autres points du réseau, par exemple des points proches des extrémités. Un appareil de mesure peut être, par exemple, un oscilloscope numérique à mémoire.

Avantageusement, on réalise une mesure du signal reçu à chaque extrémité du réseau. Cependant, dans un mode de réalisation secondaire de l'invention, il est possible de ne réaliser des mesures qu'à une partie des extrémités du réseau. Autrement dit, l'invention peut être mise en œuvre à partir d'au moins deux mesures réalisées à deux extrémités. Un avantage à l'utilisation d'un nombre de mesures égal au nombre d'extrémités du réseau est que cela garantie une levée totale des ambigüités de localisation des défauts. Dans le cas où le nombre de mesures est inférieur au nombre d'extrémités du réseau, des ambigüités de localisation peuvent subsister, selon la topologie du réseau, mais l'invention permet tout de même de fournir une information sur les positions potentielles du ou des défauts.

Les mesures enregistrées sont du type de celles décrites aux figures 3a, 3b, 3c. Elles consistent chacune en un enregistrement du signal reçu en un point du réseau sur une durée temporelle prédéterminée.

Le procédé selon l'invention peut être activé lorsque la signature d'un défaut est identifiée sur au moins une mesure ou peut être exécuté en permanence en effectuant des enregistrements successifs. Un intérêt d'exécuter l'invention en permanence est de pouvoir détecter des défauts intermittents, c'est-à-dire des défauts qui engendrent une onde de choc dans le réseau pendant un intervalle de temps court.

L'invention peut aussi être appliquée à la détection de défauts permanents et peut être couplée à une méthode dite de réflectométrie, qui consiste à injecter au préalable un signal de test dans le réseau puis à mesurer les réflexions de ce signal de test sur un défaut éventuel.

Dans une deuxième étape 502, les mesures enregistrées sont retournées temporellement, c'est-à-dire qu'on applique à chaque mesure une opération consistant à inverser temporellement l'ordre des échantillons.

Dans une troisième étape 503, on construit une fonction de coût F(x,t) dépendant du temps t et de la position x d'un point dans le réseau, à partir des mesures retournées temporellement.

La position x d'un point est évaluée par la distance du point à chaque extrémité du réseau $d(x,x_e)$.

La fonction de coût $F(x,t)$ représente une estimée du signal, mesuré à chaque instant t et en chaque position x du réseau de lignes, résultant de l'injection, à chaque extrémité du réseau, du signal retourné temporellement à l'étape 502. Autrement dit, la fonction de coût $F(x,t)$ vise à estimer le signal correspondant à la superposition des différents signaux retournés temporellement et injectés à chaque extrémité du réseau. Appliquée à l'exemple de la figure 3, l'étape 503 du procédé vise à estimer le signal mesuré en chaque instant et en tout point du réseau suite à l'injection aux points A, B et C des mesures $S(A,-t)$, $S(B,-t)$, $S(C,-t)$ réalisées à l'étape 501 puis retournées temporellement à l'étape 502.

La fonction de coût $F(x,t)$ est calculée indépendamment pour chaque segment du réseau de lignes qui peut être représenté par la succession des différents segments qui le composent. Par exemple, le réseau de la figure 2 peut être représenté sous la forme indiquée à la figure 4 par la succession des trois segments [AD], [DB] et [DC], le défaut étant apparu au point E appartenant au segment [DB]. L'ordre et l'agencement des segments n'a pas d'importance.

Pour chaque segment, on calcule la fonction de coût $F(x,t)$ en sommant les différentes mesures de signaux retournés temporellement et retardés du temps de propagation d'une onde entre le point de mesure (qui est aussi le point d'injection simulé du signal retourné temporellement) et un point du réseau de coordonnée x.

Ainsi, la fonction de coût $F(x,t)$ peut être représentée par la formule suivante :

$$\forall (x,t) \in \omega_b \times [0, T_{rec} + T_{max}], \ F(x,t) = \sum_{e=1}^{NbE}\left[ SR_e\left(t - \frac{d(x,x_e)}{v}\right)\right] \qquad (1)$$

$\omega_b$ est l'ensemble des points de la branche b du réseau,

$T_{rec}$ et $T_{max}$ sont respectivement le temps total d'enregistrement des signaux et le temps mis par un signal pour parcourir la distance maximale présente dans le réseau.

NbE est le nombre d'enregistrements en différents points du réseau effectué à l'étape 501. Ce nombre est au moins égal à deux et au plus égal au nombre d'extrémités du réseau.

$SR_e(t)$ est la mesure du signal réalisée au point e et retournée temporellement,

$d(x,x_e)$ est la distance entre un point quelconque du réseau, de coordonnée x, et une extrémité du réseau, de coordonnée $x_e$,

v représente la vitesse de propagation des signaux dans le réseau et donc $d(x,x_e)/v$ représente la durée pour que le signal parcourt la distance $d(x,x_e)$.

Selon une première variante de réalisation, la fonction de coût $F(x,t)$ peut être modifiée pour tenir compte de l'atténuation des ondes lors de leur propagation dans chaque segment du réseau. La relation (1) devient alors :

$$F(x,t) = \sum_{e=1}^{NbE}\left[ SR_e\left(t - \frac{d(x,x_e)}{v}\right) \times e^{\propto_b d(x,x_e)}\right]$$

$\alpha_b$ est un coefficient d'atténuation totale du signal durant tout le parcours du signal entre les points de coordonnées respectives $x_e$ et x.

Selon une seconde variante de réalisation, la fonction de coût $F(x,t)$ peut également être modifiée pour tenir compte des pertes d'énergie du signal lors de son passage à travers une jonction entre deux segments. En effet, en reprenant l'exemple de la figure 2, lorsque le signal généré au point E vers le point A, arrive à la jonction D, une partie seulement de son énergie est transmise vers le point A. Pour tenir compte de ce phénomène, la relation (1) peut être modifiée de la façon suivante :

$$F(x,t) = \sum_{e=1}^{NbE}\left[ SR_e\left(t - \frac{d(x,x_e)}{v}\right) \times \frac{1}{C_e^b}\right]$$

$C_e^b$ est le coefficient de transmission cumulé entre l'extrémité e et la branche b. Dans le cas où plus d'une jonction est traversée par le signal, le coefficient $C_e^b$ est obtenu en multipliant les coefficients de transmission associés à chaque jonction traversée.

En prenant en compte à la fois les atténuations et les coefficients de transmission, on arrive à la relation suivante :

$$F(x,t) = \sum_{e=1}^{NbE} \left[ SR_e \left( t - \frac{d(x,x_e)}{v} \right) \times \frac{1}{C_e^b} \times e^{\propto_b d(x,x_e)} \right]$$

Dans une étape 504, on recherche ensuite au moins un extremum de la fonction F(x,t) dont les coordonnées indiquent l'emplacement et l'apparition d'un défaut.

Toute méthode de résolution numérique permettant de rechercher un ou plusieurs extrema d'une fonction à deux variables peut être envisagée pour réaliser l'étape 504.

Par exemple, un algorithme de descente du gradient tel que décrit dans le document « J. Nocedal, S. Wright, "Numerical Optimization", Springer-Verlag New York, 2006, ISBN 978-0-387-30303-1 » peut être envisagé. L'extremum recherché peut être un maximum ou un minimum selon l'algorithme utilisé.

La recherche d'extrema peut se faire en deux temps. Dans un premier temps, on recherche un extremum de la fonction calculée pour chaque segment. Dans un second temps, on recherche un extremum sur les extrema identifiés pour chaque segment.

Mais la recherche d'extrema peut aussi se faire directement en construisant une unique fonction par morceaux sur plusieurs intervalles correspondant chacun à un segment.

L'étape 504 peut viser la recherche d'un unique extremum lorsque le but de la méthode est de localiser un seul défaut, mais elle peut également viser la recherche de plusieurs extrema correspondant à plusieurs défauts distincts. Pour ce second cas, l'algorithme de recherche d'extrema doit être couplé à un seuil de détection permettant de discriminer les extrema correspondant à des évènements associés à des défauts, des extrema correspondant à des artefacts liés au bruit.

Dans une dernière étape 505, les coordonnées $(x_d, t_d)$ de l'extremum ou des extrema sont retenues pour localiser un ou plusieurs défauts dans le réseau. La coordonnée $x_d$ permet de localiser le défaut par rapport aux extrémités du réseau ou plus généralement aux points de mesure de l'étape 501. La coordonnée $t_d$ permet d'identifier l'instant d'apparition du défaut dans un référentiel de temps synchronisé avec les instants auxquels les mesures sont effectuées à l'étape 501.

Le procédé selon l'invention présente notamment l'avantage d'être faiblement coûteux et donc de pouvoir être implémenté dans un dispositif embarqué. Ainsi, l'invention permet de réaliser une analyse en temps réel de l'état de santé d'un réseau filaire et notamment de détecter l'apparition de défauts intermittents qui peuvent être les prémices de dégradations plus importantes dans un câble.

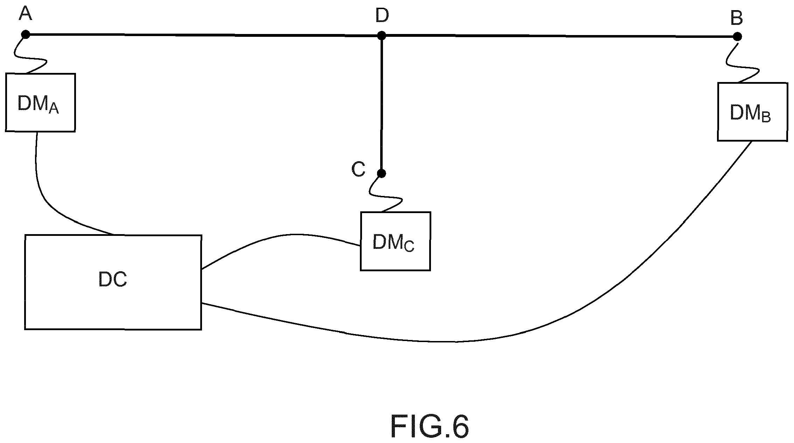

La figure 6 schématise un dispositif d'analyse apte à mettre en œuvre l'invention.

Un tel dispositif comprend au moins un équipement de mesure $DM_A$, $DM_B$, $DM_C$, pour acquérir une mesure d'un signal se propageant dans le réseau filaire jusqu'aux points de mesure A, B et C. Un tel équipement de mesure peut être, par exemple, un oscilloscope ou tout autre dispositif équivalent. Le dispositif selon l'invention peut comprendre un seul équipement de mesure apte à réaliser des mesures en différents points A,B,C du réseau ou au contraire plusieurs équipements de mesure dédiés à une mesure en un unique point.

Le dispositif selon l'invention comprend également un composant électronique DC de type circuit intégré, tel un circuit à logique programmable, par exemple de type FPGA ou un micro-contrôleur, par exemple un processeur de signal numérique, qui reçoit les mesures et qui est configuré pour exécuter le procédé selon l'invention afin de détecter et localiser un ou plusieurs défaut.

En outre, une unité de traitement, de type ordinateur, assistant numérique personnel ou autre dispositif électronique ou informatique équivalent peut être utilisé pour piloter le dispositif selon l'invention et afficher les résultats des calculs effectués par le composant DC sur une interface homme-machine, en particulier les informations de détection et localisation de défauts sur le câble.

Le procédé selon l'invention peut être implémenté sur le composant DC à partir d'éléments matériels et/ou logiciels.

Le procédé selon l'invention peut être implémenté directement par un processeur embarqué ou dans un dispositif spécifique. Le processeur peut être un processeur générique, un processeur spécifique, un circuit intégré propre à une application (connu aussi sous le nom anglais d'ASIC pour « Application-Specific Integrated Circuit ») ou un réseau de portes programmables in situ (connu aussi sous le nom anglais de FPGA pour « Field-Programmable Gâte Array »). Le dispositif selon l'invention peut utiliser un ou plusieurs circuits électroniques dédiés ou un circuit à usage général. La technique de l'invention peut se réaliser sur une machine de calcul reprogrammable (un processeur ou un micro contrôleur par exemple) exécutant un programme comprenant une séquence d'instructions, ou sur une machine de calcul dédiée (par exemple un ensemble de portes logiques comme un FPGA ou un ASIC, ou tout autre module matériel).

Le procédé selon l'invention peut également être mis en œuvre exclusivement en tant que programme d'ordinateur, le procédé étant alors appliqué à des mesures de signaux préalablement enregistrées. Dans un tel cas, l'invention peut être mise en œuvre en tant que programme d'ordinateur comportant des instructions pour son exécution. Le programme d'ordinateur peut être enregistré sur un support d'enregistrement lisible par un processeur.

La référence à un programme d'ordinateur qui, lorsqu'il est exécuté, effectue l'une quelconque des fonctions décrites précédemment, ne se limite pas à un programme d'application s'exécutant sur un ordinateur hôte unique. Au contraire, les termes programme d'ordinateur et logiciel sont utilisés ici dans un sens général pour faire référence à tout type de code informatique (par exemple, un logiciel d'application, un micro logiciel, un microcode, ou toute autre forme d'instruction d'ordinateur) qui peut être utilisé pour programmer un ou plusieurs processeurs pour mettre en œuvre des aspects des techniques décrites ici. Les moyens ou ressources informatiques peuvent notamment être distribués ("*Cloud computing"*), éventuellement selon des technologies de pair-à-pair. Le code logiciel peut être exécuté sur n'importe quel processeur approprié (par exemple, un microprocesseur) ou cœur de processeur ou un ensemble de processeurs, qu'ils soient prévus dans un dispositif de calcul unique ou répartis entre plusieurs dispositifs de calcul (par exemple tels qu'éventuellement accessibles dans l'environnement du dispositif). Le code exécutable de chaque programme permettant au dispositif programmable de mettre en œuvre les processus selon l'invention, peut être stocké, par exemple, dans le disque dur ou en mémoire morte. De manière générale, le ou les programmes pourront être chargés dans un des moyens de stockage du dispositif avant d'être exécutés. L'unité centrale peut commander et diriger l'exécution des instructions ou portions de code logiciel du ou des programmes selon l'invention, instructions qui sont stockées dans le disque dur ou dans la mémoire morte ou bien dans les autres éléments de stockage précités

## Revendications

1. Procédé d'analyse de défaut dans un réseau de lignes de transmission comprenant au moins un segment de ligne et ayant plusieurs extrémités, ledit procédé comprenant les étapes de :

   - Acquérir (501), en au moins deux extrémités du réseau de lignes, une mesure d'un signal se propageant dans le réseau de lignes,
   - Appliquer (502) un retournement temporel à chaque mesure de signal,
   - Pour chaque segment du réseau de lignes, construire (503) une fonction de coût dépendante du temps et de la distance d'un point du segment à une extrémité du réseau de lignes, en sommant les mesures de signaux retournés temporellement et retardés du temps de propagation du signal entre un point du segment et l'extrémité du réseau de lignes associée à la mesure,
   - Rechercher (504) au moins un extremum de la fonction de coût sur l'ensemble des segments du réseau de lignes et retenir les coordonnées de l'extremum,
   - En déduire (505) la présence d'un défaut à une position et un instant d'apparition donnés par les coordonnées de l'extremum.

2. Procédé d'analyse de défaut dans un réseau de lignes de transmission selon la revendication 1 dans lequel, pour construire la fonction de coût, les mesures de signaux retournés temporellement et retardés sont pondérées par une estimée de l'inverse du coefficient de transmission cumulé entre l'extrémité associée à la mesure et le segment du réseau de lignes.

3. Procédé d'analyse de défaut dans un réseau de lignes de transmission selon l'une des revendications précédentes dans lequel, pour construire la fonction de coût, les mesures de signaux retournés temporellement et retardés sont pondérées par une estimée d'un coefficient d'atténuation dépendant de la distance entre un point du segment et l'extrémité du réseau de lignes associée à la mesure.

4. Procédé d'analyse de défaut dans un réseau de lignes de transmission selon la revendication 3 dans lequel l'estimée d'un coefficient d'atténuation dépend du segment de réseau de lignes.

5. Procédé d'analyse de défaut dans un réseau de lignes de transmission selon l'une des revendications précédentes comprenant en outre la construction d'une fonction de coût par morceaux définie sur plusieurs intervalles par la fonction de coût correspondant à chaque segment du réseau de lignes.

6. Procédé d'analyse de défaut dans un réseau de lignes de transmission selon l'une des revendications précédentes dans lequel la recherche (504) d'au moins un extremum de la fonction de coût est réalisée au moyen d'un algorithme d'optimisation du type algorithme de descente du gradient.

**7.** Procédé d'analyse de défaut dans un réseau de lignes de transmission selon l'une des revendications précédentes comprenant au préalable une détection d'impulsion caractéristique de la présence d'un défaut dans au moins une des mesures.

**8.** Dispositif d'analyse de défaut dans un réseau de lignes de transmission comprenant au moins un segment de ligne et ayant plusieurs extrémités, le dispositif comprenant :

- au moins un appareil de mesure ($DM_A$, $DM_B$, $DM_C$) pour acquérir, en au moins deux extrémités du réseau de lignes, une mesure d'un signal se propageant dans le réseau de lignes,
- un composant (DC) configuré pour :

• Appliquer un retournement temporel à chaque mesure de signal,
• Pour chaque segment du réseau de lignes, construire une fonction de coût dépendante du temps et de la distance d'un point du segment à une extrémité du réseau de lignes, en sommant les mesures de signaux retournés temporellement et retardés du temps de propagation du signal entre un point du segment et l'extrémité du réseau de lignes associée à la mesure,
• Rechercher au moins un extremum de la fonction de coût sur l'ensemble des segments du réseau de lignes et retenir les coordonnées de l'extremum,
• En déduire la présence d'un défaut à une position et un instant d'apparition donnés par les coordonnées de l'extremum.

**9.** Dispositif d'analyse de défaut selon la revendication 8 comprenant en outre un moyen d'affichage de la position et de l'instant d'apparition d'un défaut.

**10.** Programme d'ordinateur comportant des instructions pour l'exécution du procédé d'analyse de défauts selon l'une quelconque des revendications 1 à 7, lorsque le programme est exécuté par un processeur.

**11.** Support d'enregistrement lisible par un processeur sur lequel est enregistré un programme comportant des instructions pour l'exécution du procédé d'analyse de défauts selon l'une quelconque des revendications 1 à 7, lorsque le programme est exécuté par un processeur.

**Patentansprüche**

**1.** Verfahren zur Analyse von Fehlern in einem Übertragungsleitungsnetz, umfassend mindestens ein Leitungssegment und aufweisend eine Mehrzahl von Enden, wobei das Verfahren die folgenden Schritte umfasst:

- Erfassen (501), an mindestens zwei Enden des Leitungsnetzes, einer Messung eines Signals, das sich in dem Leitungsnetz ausbreitet,
- Anwenden (502) einer Zeitumkehr auf jede Signalmessung,
- für jedes Segment des Leitungsnetzes, Konstruieren (503) einer Kostenfunktion abhängig von der Zeit und dem Abstand von einem Punkt des Segments zu einem Ende des Leitungsnetzes durch Addieren der Messungen der Signale, die zeitumgekehrt und um die Ausbreitungszeit des Signals zwischen einem Punkt des Segments und dem Ende des der Messung zugeordneten Leitungsnetzes verzögert sind,
- Suchen (504) nach mindestens einem Extremum der Kostenfunktion über die gesamten Segmente des Leitungsnetzes und Beibehalten der Koordinaten des Extremums,
- Ableiten (505) von diesem des Vorliegens eines Fehlers an einer Position und eines Zeitpunktes des Auftretens, die durch die Koordinaten des Extremums gegeben sind.

**2.** Verfahren zur Analyse von Fehlern in einem Übertragungsleitungsnetz nach Anspruch 1, wobei zum Konstruieren der Kostenfunktion die Messungen von zeitumgekehrten und verzögerten Signalen durch eine Schätzung der Umkehrung des kumulierten Übertragungskoeffizienten zwischen dem der Messung zugeordneten Ende und dem Segment des Leitungsnetzes gewichtet werden.

**3.** Verfahren zur Analyse von Fehlern in einem Übertragungsleitungsnetz nach einem der vorhergehenden Ansprüche, wobei zum Konstruieren der Kostenfunktion die Messungen von zeitumgekehrten und verzögerten Signale durch eine Schätzung eines Dämpfungskoeffizienten abhängig von dem Abstand zwischen einem Punkt des Segments und dem Ende des der Messung zugeordneten Leitungsnetzes gewichtet werden.

**4.** Verfahren zur Analyse von Fehlern in einem Übertragungsleitungsnetz nach Anspruch 3, wobei die Schätzung eines Dämpfungskoeffizienten von dem Segment des Leitungsnetzes abhängt.

**5.** Verfahren zur Analyse von Fehlern in einem Übertragungsleitungsnetz nach einem der vorhergehenden Ansprüche, des Weiteren umfassend die Konstruktion einer stückweisen Kostenfunktion, die über eine Mehrzahl von Intervallen durch die Kostenfunktion, die jedem Segment des Leitungsnetzes entspricht, definiert ist.

**6.** Verfahren zur Analyse von Fehlern in einem Übertragungsleitungsnetz nach einem der vorhergehenden Ansprüche, wobei die Suche (504) nach mindestens einem Extremum der Kostenfunktion mittels eines Optimierungsalgorithmus vom Typ des Gradientenabstieg-Algorithmus durchgeführt wird.

**7.** Verfahren zur Analyse von Fehlern in einem Übertragungsleitungsnetz nach einem der vorhergehenden Ansprüche, umfassend eine vorausgehende Erkennung eines Impulses, der für das Vorliegen eines Fehlers in mindestens einer der Messungen charakteristisch ist.

**8.** Vorrichtung zur Analyse von Fehlern in einem Übertragungsleitungsnetz, umfassend mindestens ein Leitungssegment und aufweisend eine Mehrzahl von Enden, wobei die Vorrichtung Folgendes umfasst:

- mindestens ein Messgerät ($DM_A$, $DM_B$, $DM_C$) zum Erfassen, an mindestens zwei Enden des Leitungsnetzes, einer Messung eines Signals, das sich in dem Leitungsnetz ausbreitet,
- ein Bauteil (DC), das für Folgendes konfiguriert ist:

  • Anwenden einer Zeitumkehr bei jeder Signalmessung,
  • für jedes Segment des Leitungsnetzes, Konstruieren einer Kostenfunktion abhängig von der Zeit und dem Abstand von einem Punkt des Segments zu einem Ende des Leitungsnetzes durch Addieren der Messungen der Signale, die zeitumgekehrt und um die Ausbreitungszeit des Signals zwischen einem Punkt des Segments und dem Ende des der Messung zugeordneten Leitungsnetzes verzögert sind,
  • Suchen nach mindestens einem Extremum der Kostenfunktion über die gesamten Segmente des Leitungsnetzes und Beibehalten der Koordinaten des Extremums,
  • Ableiten von diesem des Vorliegens eines Fehlers an einer Position und eines Zeitpunktes des Auftretens, die durch die Koordinaten des Extremums gegeben sind.

**9.** Vorrichtung zur Analyse von Fehlern nach Anspruch 8, des Weiteren umfassend Mittel zum Anzeigen der Position und des Zeitpunktes des Auftretens eines Fehlers.

**10.** Computerprogramm, umfassend Anweisungen zum Ausführen des Verfahrens zur Analyse von Fehlern nach einem der Ansprüche 1 bis 7, wenn das Programm von einem Prozessor ausgeführt wird.

**11.** Speichermedium, das von einem Prozessor lesbar ist, auf dem ein Programm gespeichert ist, das Anweisungen zum Ausführen des Verfahrens zur Analyse von Fehlern nach einem der Ansprüche 1 bis 7 umfasst, wenn das Programm von einem Prozessor ausgeführt wird.


**Claims**

**1.** A method for analysing faults in a transmission line network comprising at least one line segment and having a plurality of ends, said method comprising the steps of:

- acquiring (501), at at least two ends of the line network, a measurement of a signal being propagated in the line network,
- applying (502) a time reversal to each signal measurement,
- for each segment of the line network, constructing (503) a cost function dependent on the time and the distance from a point of the segment to an end of the line network, by adding together the measurements of signals which are time-reversed and delayed by the propagation time of the signal between a point of the segment and the end of the line network associated with the measurement,
- searching (504) for at least one extremum of the cost function over all of the segments of the line network and retaining the coordinates of the extremum,
- deducing (505) therefrom the presence of a fault at a position and an instant of occurrence that are given by the coordinates of the extremum.

2. The method for analysing faults in a transmission line network according to claim 1, wherein, to construct the cost function, the measurements of time-reversed and delayed signals are weighted by an estimate of the inverse of the aggregated transmission coefficient between the end associated with the measurement and the segment of the line network.

3. The method for analysing faults in a transmission line network according to one of the preceding claims, wherein, to construct the cost function, the measurements of time-reversed and delayed signals are weighted by an estimate of an attenuation coefficient dependent on the distance between a point of the segment and the end of the line network associated with the measurement.

4. The method for analysing faults in a transmission line network according to claim 3, wherein the estimate of an attenuation coefficient depends on the segment of line network.

5. The method for analysing faults in a transmission line network according to one of the preceding claims, further comprising the construction of a piecewise cost function defined over a plurality of intervals by the cost function corresponding to each segment of the line network.

6. The method for analysing faults in a transmission line network according to one of the preceding claims, wherein the search (504) for at least one extremum of the cost function is performed by means of an optimisation algorithm of the gradient descent algorithm type.

7. The method for analysing faults in a transmission line network according to one of the preceding claims, comprising a preliminary detection of a pulse characteristic of the presence of a fault in at least one of the measurements.

8. A device for analysing faults in a transmission line network comprising at least one line segment and having a plurality of ends, the device comprising:

   - at least one measurement unit ($DM_A$, $DM_B$, $DM_C$) for acquiring, at at least two ends of the line network, a measurement of a signal being propagated in the line network,
   - a component (DC) configured to:

      • apply a time reversal to each signal measurement,
      • for each segment of the line network, construct a cost function dependent on the time and on the distance from a point of the segment to an end of the line network, by adding together the measurements of signals which are time-reversed and delayed by the propagation time of the signal between a point of the segment and the end of the line network associated with the measurement,
      • search for at least one extremum of the cost function over all of the segments of the line network and retaining the coordinates of the extremum,
      • deduce therefrom the presence of a fault at a position and an instant of occurrence that are given by the coordinates of the extremum.

9. The device for analysing faults according to claim 8, further comprising a means for displaying the position and the instant of occurrence of a fault.

10. A computer program comprising instructions for executing the method for analysing faults according to any one of claims 1 to 7, when the program is run by a processor.

11. A processor-readable storage medium on which is stored a program comprising instructions for executing the method for analysing faults according to any of claims 1 to 7, when the program is run by a processor.

EP 3 545 319 B1

FIG.1

FIG.2

FIG.3a

FIG.3b

FIG.3c

FIG.4

```
┌─────────────────────────┐
│                         │          ╭─ 501
│   Acquisition mesures    │  ～～～
│                         │
└─────────────────────────┘
     │ S_A(t)  │ S_B(t)   │ S_C(t)
     ▼         ▼          ▼
┌─────────────────────────┐
│                         │          ╭─ 502
│     Retournement         │  ～～～
│      temporel            │
└─────────────────────────┘
     │ S_A(-t) │ S_B(-t)  │ S_C(-t)
     ▼         ▼          ▼
┌─────────────────────────┐
│                         │          ╭─ 503
│  Construction fonction   │  ～～～
│      de coût             │
└─────────────────────────┘
           │ F(x,t)
           ▼
┌─────────────────────────┐
│                         │          ╭─ 504
│    Recherche extremum    │  ～～～
│                         │
└─────────────────────────┘
           │ F(x_d,t_d)
           ▼
┌─────────────────────────┐
│                         │          ╭─ 505
│    Localisation défaut   │  ～～～
│                         │
└─────────────────────────┘
           │ (x_d,t_d)
           ▼
```

Acquisition mesures — 501

$S_A(t)$   $S_B(t)$   $S_C(t)$

Retournement temporel — 502

$S_A(-t)$   $S_B(-t)$   $S_C(-t)$

Construction fonction de coût — 503

$F(x,t)$

Recherche extremum — 504

$F(x_d,t_d)$

Localisation défaut — 505

$(x_d,t_d)$

# FIG.5

FIG.6

EP 3 545 319 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20140300370 A

**Littérature non-brevet citée dans la description**

- **M. FINK.** Time Reversai of ultrasonic fields - Basic principles. *IEEE Trans. Ultrason., Ferroelec., Freq. Contr.,* 1992, vol. 39 (5), 555-566

- **J. NOCEDAL ; S. WRIGHT.** Numerical Optimization. Springer-Verlag, 2006